# EUROPEAN PATENT APPLICATION

(11) **EP 4 637 026 A1**
(43) Date of publication of application: **22.10.2025**
(21) Application number: 24905721.7
(22) Date of filing: 26.09.2024
(51) Int. Cl.: H02S 40/00

(54) **SOLAR CELL AND PHOTOVOLTAIC MODULE**

(30) Priority: 07.02.2024 CN 202410175427
(71) Applicant: Longi Green Energy Technology Co., Ltd., Xi'an, Shaanxi 710100 (CN)
(72) Inventor: LI, Zhenguo, Xi' an, Shaanxi 710100 (CN); TONG, Hongbo, Xi' an, Shaanxi 710100 (CN); LIU, Qingping, Xi' an, Shaanxi 710100 (CN); DING, Chao, Xi' an, Shaanxi 710100 (CN); DONG, Guangbin, Xi' an, Shaanxi 710100 (CN); HE, Jinhua, Xi' an, Shaanxi 710100 (CN); ZHANG, Hongchao, Xi' an, Shaanxi 710100 (CN); XU, Xinxing, Xi' an, Shaanxi 710100 (CN)
(74) Representative: Pfenning, Meinig & Partner mbB
(86) International application number: PCT/CN2024/121372
(87) International publication number: WO 2025/130231

(57) **Abstract**

The present application provides a solar cell and a photovoltaic module. The solar cell includes: a silicon substrate and a passivation anti-reflection layer located on the silicon substrate. A surface of the silicon substrate has a textured structure, including: a plurality of quasi-pyramidal structures, which includes a pyramidal face and a pyramidal apex. The pyramidal face includes: a first sub-pyramidal face away from the pyramidal apex, and a second sub-pyramidal face. In the pyramidal face of the quasi-pyramidal structure, a surface morphology of the first sub-pyramidal face is different from a surface morphology of the second sub-pyramidal face. The passivation anti-reflection layer includes: a first portion located on the first sub-pyramidal face, and a second portion located on the second sub-pyramidal face. A thickness of the first portion of the passivation anti-reflection layer along the direction towards the pyramidal apex is greater than a thickness of the second portion along the direction towards the pyramidal apex.

## Description

### CROSS-REFERENCE TO RELATED APPLICATIONS

The present application claims priority to Chinese Patent Application No. 202410175427.9, filed with the China National Intellectual Property Administration on February 07, 2024, and entitled "SOLAR CELL AND PHOTOVOLTAIC MODULE", which is incorporated herein by reference in its entirety.

### TECHNICAL FIELD

The present application relates to the field of photovoltaic technologies, and in particular, to a solar cell and a photovoltaic module.

### BACKGROUND

Solar cells convert light energy into electric energy by means of a photovoltaic effect. Since the solar cells use clean energy, they have broad application prospects.

In solar cells, especially on the front side of the solar cells, functional film layers such as a passivation anti-reflection layer are provided. On one hand, these film layers serve to passivate defects; on the other hand, it is also desired to provide a relatively good anti-reflection effect in order to enhance the short-circuit current, etc. However, in existing solar cells, varying passivation and anti-reflection effects at different positions of a textured structure have not been considered. This has resulted in either a thicker passivation film that affects light absorption, or a thinner passivation film that compromises the passivation effect, thereby impacting the performance of the solar cell.

### SUMMARY

The present application provides a solar cell and a photovoltaic module, aiming at addressing the challenge of achieving both passivation and anti-reflection effects in solar cells based on considering a textured structure. In a first aspect of the present application, a solar cell is provided, including:
a silicon substrate and a passivation anti-reflection layer located on the silicon substrate, where
a surface of the silicon substrate has a textured structure including: a plurality of quasi-pyramidal structures; a quasi-pyramidal structure includes: a pyramidal face and a pyramidal apex; the pyramidal face of the quasi-pyramidal structure includes: a first sub-pyramidal face away from the pyramidal apex, and a second sub-pyramidal face, where the second sub-pyramidal face is the remaining portion of the pyramidal face of the quasi-pyramidal structure other than the first sub-pyramidal face; and in the pyramidal face of the quasi-pyramidal structure, a surface morphology of the first sub-pyramidal face is different from a surface morphology of the second sub-pyramidal face;
the passivation anti-reflection layer includes: a first portion located on the first sub-pyramidal face, and a second portion located on the second sub-pyramidal face; and a thickness of the first portion of the passivation anti-reflection layer along a direction towards the pyramidal apex is greater than a thickness of the second portion of the passivation anti-reflection layer along the direction towards the pyramidal apex.

In the present application, in the pyramidal face of the quasi-pyramidal structure, a surface morphology of the first sub-pyramidal face is different from a surface morphology of the second sub-pyramidal face. The shape of the pyramidal face of the quasi-pyramidal structure is more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. In the silicon substrate, the situation in the portion abutting the quasi-pyramidal structure is more complicated, and there are usually more gaps; and the situation in a portion at the position where adjacent quasi-pyramidal structures abut is also more complicated, and there are also usually more gaps. Therefore, a relatively thick passivation anti-reflection layer is required at these positions to achieve a relatively good passivation effect. Therefore, a relatively thick passivation anti-reflection layer is also required on the first sub-pyramidal face abutting these positions to achieve a relatively good passivation effect. In contrast, there are usually relatively few gaps at the pyramidal apex, so only a relatively thin passivation anti-reflection layer is required to achieve a relatively good passivation effect, and therefore, a relatively thin passivation anti-reflection layer is also required on the second sub-pyramidal face abutting the pyramidal apex to achieve a better passivation effect. Accordingly, in the present application, the thickness of the first portion along a direction towards the pyramidal apex is greater than the thickness of the second portion along the direction towards the pyramidal apex. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look. In summary, the present application not only ensures an excellent passivation effect throughout a solar cell, but also greatly improves the anti-reflection effect and also reduces waste.

In some embodiments, a surface fluctuation of the first sub-pyramidal face is less than surface fluctuation of the second sub-pyramidal face;
or a roughness of the first sub-pyramidal face is less than a roughness of the second sub-pyramidal face.

In some embodiments, the thickness of the first portion of the passivation anti-reflection layer is greater than a thickness of a portion of the passivation anti-reflection layer at the pyramidal apex; and/or
a thickness of a portion at a position of the passivation anti-reflection layer where adjacent quasi-pyramidal structures abut is greater than the thickness of the portion of the passivation anti-reflection layer at the pyramidal apex; and/or
the thickness of the portion of the passivation anti-reflection layer at the position where adjacent quasi-pyramidal structures abut is greater than the thickness of the second portion of the passivation anti-reflection layer.

In some embodiments, a thickness non-uniformity between the first portion and the second portion in the passivation anti-reflection layer is greater than 4%; wherein the thickness non-uniformity is an absolute value of a difference between a first thickness of the first portion at a first position along the direction towards the pyramidal apex and a second thickness of the second portion at a second position along the direction towards the pyramidal apex, divided by a sum of the first thickness and the second thickness.

In some embodiments, the solar cell further includes: an aluminum oxide layer located between the silicon substrate and the passivation anti-reflection layer, wherein:
the aluminum oxide layer includes: a third portion located on the first sub-pyramidal face, and a fourth portion located on the second sub-pyramidal face;
a thickness non-uniformity between the first portion and the second portion in the passivation anti-reflection layer is greater than a thickness non-uniformity between the third portion and the fourth portion in the aluminum oxide layer;
the thickness non-uniformity between the first portion and the second portion in the passivation anti-reflection layer is an absolute value of a difference between a first thickness of the first portion at a first position along the direction towards the pyramidal apex and a second thickness of the second portion at a second position along the direction towards the pyramidal apex, divided by a sum of the first thickness and the second thickness; and
the thickness non-uniformity between the third portion and the fourth portion in the aluminum oxide layer is an absolute value of a difference between a third thickness of a third portion at a third position along the direction towards the pyramidal apex and a fourth thickness of the fourth portion at a fourth position along the direction towards the pyramidal apex, divided by a sum of the third thickness and the fourth thickness.

In some embodiments, the passivation anti-reflection layer includes: a front-side passivation anti-reflection layer located on a light-facing surface of the silicon substrate, and a back-side passivation anti-reflection layer located on a back side of the silicon substrate; and
at two opposite positions in a thickness direction of the silicon substrate, a thickness of the back-side passivation anti-reflection layer is greater than a thickness of the front-side passivation anti-reflection layer.

In some embodiments, at the two opposite positions in the thickness direction of the silicon substrate, a difference between the thickness of the back-side passivation anti-reflection layer and the thickness of the front-side passivation anti-reflection layer is greater than or equal to 15 nm and less than or equal to 40 nm.

In some embodiments, the pyramidal face of the quasi-pyramidal structure has a branch-like texture, and a quantity of the branch-like texture in the second sub-pyramidal face is greater than a quantity of the branch-like texture in the first sub-pyramidal face.

In some embodiments, the pyramidal apex of the quasi-pyramidal structure and the second sub-pyramidal face of the pyramidal face of the quasi-pyramidal structure have a cluster of ring-like textures disposed in a nested manner.

In some embodiments, among the cluster of ring-like textures, along a height direction of the quasi-pyramidal structure, the closer a ring-like texture is to the pyramidal apex, the smaller a contour of the ring-like texture is.

In some embodiments, a portion of the quasi-pyramidal structure away from the pyramidal apex is a lower portion of the quasi-pyramidal structure, and a height of the lower portion is at least one tenth of a height of the quasi-pyramidal structure;
the first sub-pyramidal face is a region corresponding to the lower portion of the pyramidal face of the quasi-pyramidal structure; and
the second sub-pyramidal face is a region of the pyramidal face of the quasi-pyramidal structure closer to the pyramidal apex than the first sub-pyramidal face.

In some embodiments, the quasi-pyramidal structure further includes: a bottom contour line away from the pyramidal apex, where at least two points in a same bottom contour line have a height difference.

In some embodiments, the textured structure has an apex angle of 55° to 90°.

In some embodiments, the quasi-pyramidal structure has a height of 0.2 µm to 3 µm.

In some embodiments, at least one of a light-facing surface of the silicon substrate and/or a back surface of the silicon substrate has the textured structure.

In a second aspect of the present application, a photovoltaic module is provided, including: a plurality of any one of the foregoing solar cells.

The above solar cell and photovoltaic module have the same or similar beneficial effects, and in order to avoid repetition, no more details will be given here.

### BRIEF DESCRIPTION OF THE DRAWINGS

To describe the technical solutions of the embodiments of the present application more clearly, the accompanying drawings required for describing the embodiments of the present application are briefly introduced below. Apparently, the accompanying drawings in the following description show only some of the embodiments of the present application, and a person of ordinary skill in the art can also derive other drawings from these accompanying drawings without involving creative efforts.
FIG. 1 shows a scanning electron microscope image of a first silicon substrate in an embodiment of the present application;
FIG. 2 shows a scanning electron microscope image of a second silicon substrate in an embodiment of the present application;
FIG. 3 shows a schematic diagram of a partial structure of a solar cell in an embodiment of the present application;
FIG. 4 shows a scanning electron microscope image of a third silicon substrate in an embodiment of the present application;
FIG. 5 shows a scanning electron microscope image of a fourth silicon substrate in an embodiment of the present application; and
FIG. 6 shows a graph of comparison in reflectance between the solar cell in the embodiment of the present application and a solar cell in a comparative example.

Description of reference signs:
1 - silicon substrate, 2 - passivation anti-reflection layer, 11 - pyramidal apex, 12 - branch-like texture, 13 - ring-like texture, 131 - spike, 14 - bottom contour line, and 15 - fused quasi-pyramidal structures.

### DETAILED DESCRIPTION

The technical solutions of the embodiments of the present application will be clearly and completely described below with reference to the drawings in the embodiments of the present application. Apparently, the described embodiments are some, rather than all, of the embodiments of the present application. All other embodiments obtained by a person of ordinary skill in the art based on the embodiments of the present application without making creative efforts fall within the protection scope of the present application.

In existing solar cells, it is challenging to achieve both passivation and anti-reflection effects, causing the performance of the solar cells to be affected. A main reason thereof lies in that as the thickness of the passivation anti-reflection layer increases, the passivation effect thereof becomes better; however, the anti-reflection effect decreases moderately. Therefore, it is challenging to achieve both passivation and anti-reflection effects. The main concept of the present application is to configure the shape of the pyramidal face of the quasi-pyramidal structure to be more irregular, so that the textured structure has a larger specific surface area, thereby improving the anti-reflection effect. Based on the textured structure, according to the passivation requirements at different positions, the thickness of the passivation anti-reflection layer at the corresponding position is configured to ensure that each position has an excellent passivation effect and the waste of the material used for the passivation anti-reflection layer 2 is reduced. Furthermore, after light enters the passivation anti-reflection layer having different thicknesses, the light path changes more times, so that the optical length can be increased. In combination with the textured structure of the present application, the light absorption can be further increased, and the light trapping effect is improved. That is to say, in the present application, by combining the textured structure with the passivation anti-reflection layer, the anti-reflection effect and passivation effect are both improved.

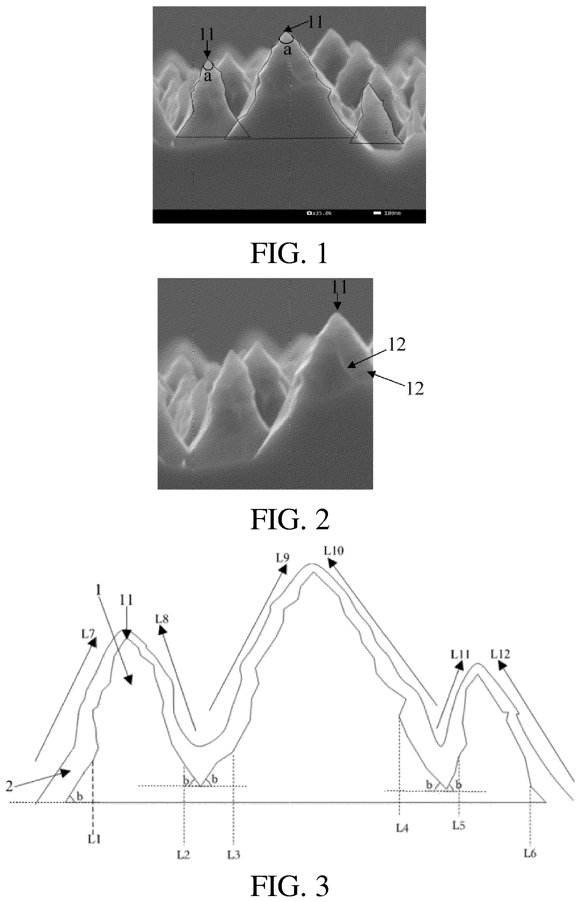

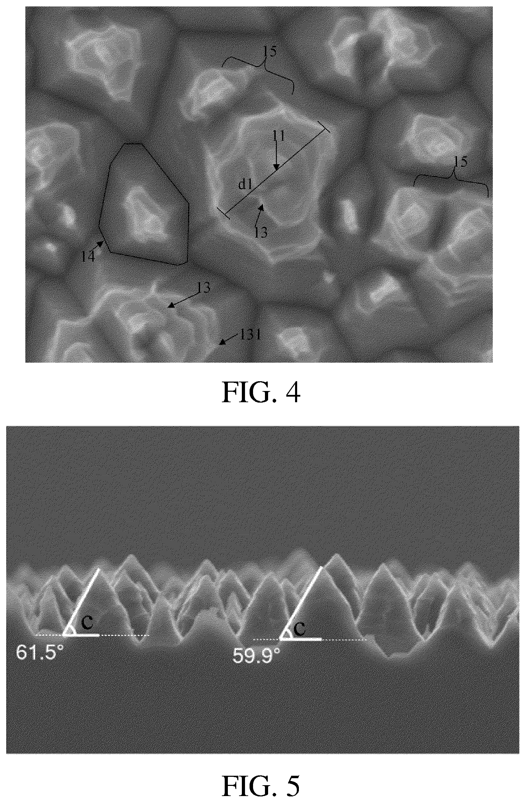

FIGs. 1, 2, and 5 are all scanning electron microscope images obtained mainly by scanning from the front side of the textured structure. FIG. 4 is a scanning electron microscope image obtained mainly by scanning in a direction from the pyramidal apex of the quasi-pyramidal structure of the textured structure to the bottom contour line.

Referring to FIGs. 1 to 5, the present application provides a solar cell, including: a silicon substrate 1 and a passivation anti-reflection layer 2 located on the silicon substrate 1. The silicon substrate 1 can have a doping element, or can be intrinsic. This is not specifically limited. The silicon substrate 1 can be a single crystal silicon substrate, etc. This is not specifically limited. The passivation anti-reflection layer 2 here can have a passivation effect and also an anti-reflection effect. The material of the passivation anti-reflection layer 2 can be selected from: silicon oxide and/or silicon oxynitride, and the specific material of the passivation anti-reflection layer 2 is not limited. The passivation anti-reflection layer 2 can be prepared by a method such as PECVD (Plasma Enhanced Chemical Vapor Deposition). The specific method for preparing the passivation anti-reflection layer 2 is not specifically limited either.

Referring to FIGs. 1 to 5, a surface of the silicon substrate 1 has a textured structure including: a plurality of quasi-pyramidal structures. For example, in FIG. 1, black lines outline three quasi-pyramidal structures in the textured structure. The quasi-pyramidal structures includes: a pyramidal face and a pyramidal apex 11. The pyramidal apex 11 is the highest point of the quasi-pyramidal structure. Where the highest portion of the quasi-pyramidal structure is a plane formed by a plurality of points at the same height, the pyramidal apex here can be a geometric center of the plane. In the quasi-pyramidal structure, the pyramidal face of the quasi-pyramidal structure is a collection of all side faces of the quasi-pyramidal structure, that is, all the surfaces of the quasi-pyramidal structure except the bottom face and the pyramidal apex. The pyramidal face of the quasi-pyramidal structure connects the pyramidal apex and the bottom contour line, and the bottom contour line is a contour line at the bottom of the quasi-pyramidal structure. The pyramidal face of the quasi-pyramidal structure includes: a first sub-pyramidal face away from the pyramidal apex, and a second sub-pyramidal face. That is to say, the first sub-pyramidal face is a portion of the pyramidal face farthest away from the pyramidal apex 11, that is, a portion of the pyramidal face close to the silicon substrate. The second sub-pyramidal face is the remaining portion of the pyramidal face other than the first sub-pyramidal face. In FIG. 3, dashed lines L1 to L6 are not actually existing in the solar cell and are only annotated to distinguish the first sub-pyramidal face from the second sub-pyramidal face, or annotated to distinguish a lower segment from a first segment as described below. For example, in FIG. 3, for the leftmost quasi-pyramidal structure, in the pyramidal face, a portion located to the right of the dashed line L1 and to the left of the pyramidal apex of the leftmost quasi-pyramidal structure and a portion located to the left of the dashed line L2 and to the right of the pyramidal apex of the leftmost quasi-pyramidal structure are the second sub-pyramidal face, and a portion located to the left of L1 and a portion located to the right of L2 are the first sub-pyramidal face. For the middle quasi-pyramidal structure, in the pyramidal face, a portion located to the right of the dashed line L3 and to the left of the pyramidal apex of the middle quasi-pyramidal structure and a portion located to the left of the dashed line L4 and to the right of the pyramidal apex of the middle quasi-pyramidal structure are the second sub-pyramidal face, and a portion located to the left of L3 and a portion located to the right of L4 are the first sub-pyramidal face. For the rightmost quasi-pyramidal structure, in the pyramidal face, a portion located to the right of the dashed line L5 and to the left of the pyramidal apex of the rightmost quasi-pyramidal structure and a portion located to the left of the dashed line L6 and to the right of the pyramidal apex of the rightmost quasi-pyramidal structure are the second sub-pyramidal face, and a portion located to the left of L5 and a portion located to the right of L6 are the first sub-pyramidal face.

The surface morphology of the sub-pyramidal face can include: surface fluctuation of the sub-pyramidal face, or a roughness of the sub-pyramidal face, etc. The surface fluctuation mainly refers to the extent of height variation caused by relatively large high and low structures on the surface, and the roughness refers to the extent of unevenness caused by micro-protrusions/micro-depressions on the surface. Referring to FIGs. 1 to 5, in the pyramidal face of the quasi-pyramidal structure, the surface morphology of the first sub-pyramidal face away from the pyramidal apex 11 is different from that of the second sub-pyramidal face, that is, the surface fluctuation, roughness, etc., of the first sub-pyramidal face are different from those of the second sub-pyramidal face. In one case, a quantity of projections and/or depressions on the second sub-pyramidal face can be greater than a quantity of projections and/or depressions on the first sub-pyramidal face. In another case, the extent of protrusion and/or depression on the second sub-pyramidal face can be greater than the extent of protrusion and/or depression on the first sub-pyramidal face. In another case, the arrangement of the protrusions and/or depressions on the second sub-pyramidal face can be more disordered than the arrangement of the protrusions and/or depressions on the first sub-pyramidal face. In another case, the height of the protrusions and/or the depth of the depressions on the second sub-pyramidal face can be greater than the height of the protrusions and/or the depth of the depressions on the first sub-pyramidal face. Thus, the shape of the pyramidal face of the quasi-pyramidal structure is more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

Referring to FIG. 3, the passivation anti-reflection layer 2 includes: a first portion located on the first sub-pyramidal face, and a second portion located on the second sub-pyramidal face. In the passivation anti-reflection layer 2, the thickness of the first portion along a direction towards the pyramidal apex is greater than the thickness of the second portion along the direction towards the pyramidal apex 11. That is to say, here, when comparing the relationship between the thickness of the first portion and the thickness of the second portion, the first portion and the second portion are defined along the same direction towards the pyramidal apex 11. Throughout the text, the first portion and the second portion along the same direction towards the pyramidal apex 11 can be understood as: the first portion and the second portion being arranged in sequence along the direction from the bottom or bottom contour line of the quasi-pyramidal structure to the pyramidal apex 11. Here, the thickness direction is perpendicular to a tangent line at a position corresponding to an outer surface of the passivation anti-reflection layer 2. Specifically, in the silicon substrate 1, the situation in the portion abutting the quasi-pyramidal structure is more complicated, and there are usually more gaps; and the situation in a portion at the position where adjacent quasi-pyramidal structures abut is also more complicated, and there are also usually more gaps. Therefore, a relatively thick passivation anti-reflection layer is required at these positions to achieve a relatively good passivation effect. Therefore, a relatively thick passivation anti-reflection layer is also required on the first sub-pyramidal face abutting these positions to achieve a relatively good passivation effect. In contrast, there are usually relatively few gaps at the pyramidal apex, so only a relatively thin passivation anti-reflection layer is required to achieve a relatively good passivation effect, and therefore, a relatively thin passivation anti-reflection layer is also required on the second sub-pyramidal face abutting the pyramidal apex to achieve a better passivation effect. Accordingly, in the present application, the thickness of the first portion along a direction towards the pyramidal apex is greater than the thickness of the second portion along the direction towards the pyramidal apex. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look. In summary, the present application not only ensures an excellent passivation effect throughout a solar cell, but also greatly improves the anti-reflection effect and also reduces waste.

As shown in FIG. 3, for the leftmost quasi-pyramidal structure, in the passivation anti-reflection layer 2, a portion located between the dashed line L1 and the dashed line L2 except the pyramidal apex 11 is the second portion, and a portion located to the left of L1 and a portion located to the right of L2 constitute the first portion; for the first portion and the second portion along the same direction L7 towards the pyramidal apex 11, the thickness of the first portion is greater than the thickness of the second portion; and for the first portion and the second portion along the same direction L8 towards the pyramidal apex 11, the thickness of the first portion is greater than the thickness of the second portion. For the middle quasi-pyramidal structure, in the passivation anti-reflection layer 2, a portion located between the dashed line L3 and the dashed line L4 except the pyramidal apex 11 is the second portion, and a portion located to the left of L3 and a portion located to the right of L4 constitute the first portion; for the first portion and the second portion along the same direction L9 towards the pyramidal apex, the thickness of the first portion is greater than the thickness of the second portion; and for the first portion and the second portion along the same direction L10 towards the pyramidal apex, the thickness of the first portion is greater than the thickness of the second portion. For the rightmost quasi-pyramidal structure, in the passivation anti-reflection layer 2, a portion located between the dashed line L5 and the dashed line L6 except the pyramidal apex is the second portion, and a portion located to the left of L5 and a portion located to the right of L6 constitute the first portion; for the first portion and the second portion along the same direction L11 towards the pyramidal apex, the thickness of the first portion is greater than the thickness of the second portion; and for the first portion and the second portion along the same direction L12 towards the pyramidal apex, the thickness of the first portion is greater than the thickness of the second portion.

It needs to be noted that thickness of a portion of the passivation anti-reflection layer 2 can be measured by using an instrument such as a transmission electron microscope. The thickness of the certain portion can be the directly measured thickness of the portion, or the thickness of the certain portion can also be, for example, an average thickness obtained by measuring a plurality of selected points in the portion. The measurement method is selected based on the measurability of actual measurement targets. This is not specifically limited.

In some embodiments, referring to FIG. 1 to FIG. 3 and FIG. 5, in the pyramidal face of the quasi-pyramidal structure, the surface fluctuation of the first sub-pyramidal face is less than the surface fluctuation of the second sub-pyramidal face, or the roughness of the first sub-pyramidal face is less than the roughness of the second sub-pyramidal face. For both the definitions of the surface fluctuation and roughness here, reference can be made to the foregoing corresponding disclosure. The shape of the pyramidal face of the quasi-pyramidal structure is more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. In FIG. 3, for the leftmost quasi-pyramidal structure, in the pyramidal face, the surface fluctuation of the first sub-pyramidal face located to the left of the dashed line L1 and the first sub-pyramidal face located to the right of the dashed line L2 is less than the surface fluctuation of the second sub-pyramidal face located to the right of the dashed line L1 and to the left of the pyramidal apex of the leftmost quasi-pyramidal structure and the second sub-pyramidal face located to the left of the dashed line L2 and to the right of the pyramidal apex of the leftmost quasi-pyramidal structure; alternatively, the roughness of the first sub-pyramidal face located to the left of the dashed line L1 and the first sub-pyramidal face located to the right of the dashed line L2 is less than the roughness of the second sub-pyramidal face located to the right of the dashed line L1 and to the left of the pyramidal apex of the leftmost quasi-pyramidal structure and the second sub-pyramidal face located to the left of the dashed line L2 and to the right of the pyramidal apex of the leftmost quasi-pyramidal structure. For the middle quasi-pyramidal structure, in the pyramidal face, the surface fluctuation of the first sub-pyramidal face located to the left of the dashed line L3 and the first sub-pyramidal face located to the right of the dashed line L4 is less than the surface fluctuation of the second sub-pyramidal face located to the right of the dashed line L3 and to the left of the pyramidal apex of the middle quasi-pyramidal structure and the second sub-pyramidal face located to the left of the dashed line L4 and to the right of the pyramidal apex of the middle quasi-pyramidal structure; alternatively, the roughness of the first sub-pyramidal face located to the left of the dashed line L3 and the first sub-pyramidal face located to the right of the dashed line L4 is less than the roughness of the second sub-pyramidal face located to the right of the dashed line L3 and to the left of the pyramidal apex of the middle quasi-pyramidal structure and the second sub-pyramidal face located to the left of the dashed line L4 and to the right of the pyramidal apex of the middle quasi-pyramidal structure. For the rightmost quasi-pyramidal structure, in the pyramidal face, the surface fluctuation of the first sub-pyramidal face located to the left of the dashed line L5 and the first sub-pyramidal face located to the right of the dashed line L6 is less than the surface fluctuation of the second sub-pyramidal face located to the right of the dashed line L5 and to the left of the pyramidal apex of the rightmost quasi-pyramidal structure and the second sub-pyramidal face located to the left of the dashed line L6 and to the right of the pyramidal apex of the rightmost quasi-pyramidal structure; alternatively, the roughness of the first sub-pyramidal face located to the left of the dashed line L5 and the first sub-pyramidal face located to the right of the dashed line L6 is less than the roughness of the second sub-pyramidal face located to the right of the dashed line L5 and to the left of the pyramidal apex of the rightmost quasi-pyramidal structure and the second sub-pyramidal face located to the left of the dashed line L6 and to the right of the pyramidal apex of the rightmost quasi-pyramidal structure.

In some embodiments, referring to FIG. 3, the thickness of the first portion in the passivation anti-reflection layer 2 is greater than the thickness of the portion at the pyramidal apex 11 in the passivation anti-reflection layer 2. Specifically, in the silicon substrate 1, the situation in the portion abutting the quasi-pyramidal structure is more complicated, and there are usually more gaps; and the situation in a portion at the position where adjacent quasi-pyramidal structures abut is also more complicated, and there are also usually more gaps. Therefore, a relatively thick passivation anti-reflection layer is required on these positions to achieve a relatively good passivation effect. Therefore, a relatively thick passivation anti-reflection layer is also required on the first sub-pyramidal face abutting those positions to achieve a relatively good passivation effect. In contrast, there are usually relatively few gaps at the pyramidal apex, so only a relatively thin passivation anti-reflection layer is required to achieve a relatively good passivation effect. Accordingly, in the present application, the thickness of the first portion in the passivation anti-reflection layer 2 is greater than the thickness of the portion at the pyramidal apex 11 in the passivation anti-reflection layer 2. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look.

For example, as shown in FIG. 3, for the leftmost quasi-pyramidal structure, the thickness of the first portion located to the left of the dashed line L1 and the first portion located to the right of the dashed line L2 in the passivation anti-reflection layer 2 is greater than the thickness of the portion at the pyramidal apex 11 of the leftmost quasi-pyramidal structure in the passivation anti-reflection layer 2. For the middle quasi-pyramidal structure, the thickness of the first portion located to the left of the dashed line L3 and the first portion located to the right of the dashed line L4 in the passivation anti-reflection layer 2 is greater than the thickness of the portion at the pyramidal apex 11 of the middle quasi-pyramidal structure in the passivation anti-reflection layer 2. For the rightmost quasi-pyramidal structure, the thickness of the first portion located to the left of the dashed line L5 and the first portion located to the right of the dashed line L6 in the passivation anti-reflection layer 2 is greater than the thickness of the portion at the pyramidal apex 11 of the rightmost quasi-pyramidal structure in the passivation anti-reflection layer 2.

Referring to FIG. 3, the portion located between the dashed line L2 and the dashed line L3 is a position where the leftmost quasi-pyramidal structure abuts the middle quasi-pyramidal structure, and the portion located between the dashed line L4 and the dashed line L5 is a position where the rightmost quasi-pyramidal structure abuts the middle quasi-pyramidal structure. In some embodiments, referring to FIG. 3, the thickness of the portion of the passivation anti-reflection layer 2 at a position where adjacent quasi-pyramidal structures abut is greater than the thickness of the portion of the passivation anti-reflection layer 2 at the pyramidal apex 11. Specifically, in the silicon substrate 1, the situation in the position where adjacent quasi-pyramidal structures abut is relatively complicated and there are usually many gaps; therefore, a relatively thick passivation anti-reflection layer is required on these positions to achieve a relatively good passivation effect. In contrast, there are usually relatively few gaps at the pyramidal apex, so only a relatively thin passivation anti-reflection layer is required to achieve a relatively good passivation effect. Accordingly, in the present application, the thickness of the portion of the passivation anti-reflection layer 2 at the position where adjacent quasi-pyramidal structures abut is greater than the thickness of the portion of the passivation anti-reflection layer 2 at the pyramidal apex 11. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look. As shown in FIG. 3, the thickness of the portion located between the dashed line L2 and the dashed line L3 in the passivation anti-reflection layer 2 is greater than the thickness of the portion at the pyramidal apex 11 of the leftmost quasi-pyramidal structure in the passivation anti-reflection layer 2, and is also greater than the thickness of the portion at the pyramidal apex 11 of the middle quasi-pyramidal structure in the passivation anti-reflection layer 2. In FIG. 3, the thickness of the portion located between the dashed line L4 and the dashed line L5 in the passivation anti-reflection layer 2 is greater than the thickness of the portion at the pyramidal apex of the rightmost quasi-pyramidal structure in the passivation anti-reflection layer 2, and is also greater than the thickness of the portion at the pyramidal apex of the middle quasi-pyramidal structure in the passivation anti-reflection layer 2.

In some embodiments, referring to FIG. 3, the thickness of the portion of the passivation anti-reflection layer 2 at a position where adjacent quasi-pyramidal structures abut is greater than the thickness of the second portion of the passivation anti-reflection layer 2. Specifically, in the silicon substrate 1, the situation in the position where adjacent quasi-pyramidal structures abut is relatively complicated and there are usually many gaps; therefore, a relatively thick passivation anti-reflection layer is required on these positions to achieve a relatively good passivation effect. In contrast, there are usually relatively few gaps at the pyramidal apex, so only a relatively thin passivation anti-reflection layer is required to achieve a relatively good passivation effect, and therefore, a relatively thin passivation anti-reflection layer is also required on the second sub-pyramidal face abutting the pyramidal apex to achieve a better passivation effect. Accordingly, in the present application, the thickness of the portion of the passivation anti-reflection layer 2 at the position where adjacent quasi-pyramidal structures abut is greater than the thickness of the second portion of the passivation anti-reflection layer 2. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look.

As shown in FIG. 3, the thickness of the portion located between the dashed line L2 and the dashed line L3 in the passivation anti-reflection layer 2 is greater than the thickness of the second portion located between the dashed line L1 and the dashed line L2 in the passivation anti-reflection layer 2 except the pyramidal apex, and is also greater than the thickness of the second portion located between the dashed line L3 and the dashed line L4 in the passivation anti-reflection layer 2 except the pyramidal apex. In FIG. 3, the thickness of the portion located between the dashed line L4 and the dashed line L5 in the passivation anti-reflection layer 2 is greater than the thickness of the second portion located between the dashed line L5 and the dashed line L6 in the passivation anti-reflection layer 2 except the pyramidal apex, and is also greater than the thickness of the second portion located between the dashed line L3 and the dashed line L4 in the passivation anti-reflection layer 2 except the pyramidal apex.

In some embodiments, a thickness non-uniformity between the first portion and the second portion in the passivation anti-reflection layer 2 is greater than 4%; and the thickness non-uniformity is an absolute value of a difference between a first thickness of the first portion at a first position along the direction towards the pyramidal apex and a second thickness of the second portion at a second position along the direction towards the pyramidal apex, divided by a sum of the first thickness and the second thickness, where the first position in the first portion is any position in the first portion, and the second position in the second portion is any position in the second portion. That is to say, here, the first portion and the second portion are defined along the same direction towards the pyramidal apex 11, and in the passivation anti-reflection layer 2, a thickness non-uniformity between the first portion and the second portion is greater than 4%. Specifically, in the silicon substrate 1, the situation in the position where adjacent quasi-pyramidal structures abut is relatively complicated and there are usually many gaps; therefore, a relatively thick passivation anti-reflection layer is required on these positions to achieve a relatively good passivation effect. In contrast, there are usually relatively few gaps at the pyramidal apex, so only a relatively thin passivation anti-reflection layer is required to achieve a relatively good passivation effect, and therefore, a relatively thin passivation anti-reflection layer is also required on the second sub-pyramidal face abutting the pyramidal apex to achieve a better passivation effect. Accordingly, in the present application, the thickness non-uniformity between the first portion and the second portion in the passivation anti-reflection layer 2 is greater than 4%. Not only can each position be guaranteed to have an excellent passivation effect, but also the thickness of the passivation anti-reflection layer is configured according to the passivation requirements in the present application, which can lead to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look.

For example, in the passivation anti-reflection layer 2, the thickness non-uniformity between the first portion and the second portion along the same direction towards the pyramidal apex can be: 4.001%, or 4.03%, or 4.09%, or 4.2%, or 4.31%, or 4.5%, or 4.9%, or 5%, or 5.2%, or 6%, or 7.23%, or 8%, or 9.2%, or 10.3%, or 11.2%, or 13.46%, or 15%, or 18%, or 20%, or 22%, or 25%.

In some embodiments, the solar cell can further include: an aluminum oxide layer (not shown in the drawings) located between the silicon substrate 1 and the passivation anti-reflection layer 2. The thickness variation of the aluminum oxide layer is less than the thickness variation of the passivation anti-reflection layer 2, where the thickness variation refers to the degree of thickness changes; the thickness variation of the aluminum oxide layer can be specifically an absolute value of a difference between the thickness of the aluminum oxide layer at a fifth position and the thickness of the aluminum oxide layer at a sixth position; and the thickness variation of the passivation anti-reflection layer 2 can be specifically an absolute value of a difference between the thickness of the passivation anti-reflection layer 2 at a seventh position and the thickness of the passivation anti-reflection layer 2 at an eighth position. In the thickness direction of the silicon substrate, projections of the fifth position and the seventh position coincide, and projections of the sixth position and the eighth position coincide. The fifth position and the sixth position are any two different positions in the aluminum oxide layer. Specifically, the aluminum oxide layer is usually obtained by means of atomic layer deposition. The atomic layer deposition is less affected by surface appearance. The thickness of the aluminum oxide layer is relatively uniform, and the aluminum oxide layer achieves a relatively good passivation performance.

It needs to be noted that the thickness of the aluminum oxide layer can be 3 nm (nanometers) to 7 nm, and the thickness of the aluminum oxide layer can also be measured by a transmission electron microscope, etc. This is not specifically limited. For example, the thickness variation of the aluminum oxide layer can be 0.0001-3 nm, for example, 0.001 nm, 0.005 nm, 0.008 nm, 0.01 nm, 0.02 nm, 0.03 nm, 0.04 nm, 0.05 nm, 0.06 nm, 0.07 nm, 0.08 nm, 0.1 nm, 0.2 nm, 0.3 nm, 0.4 nm, 0.5 nm, 0.6 nm, 0.7 nm, 0.8 nm, 1 nm, 2 nm, 2.3 nm, or 3 nm, and the thickness variation of the passivation anti-reflection layer 2 can be 3.5-50 nm, for example, 3.5 nm, 4 nm, 4.8 nm, 6 nm, 7 nm, 8 nm, 9 nm, 10 nm, 12 nm, 12.5 nm, 13 nm, 14 nm, 15 nm, 16 nm, 17 nm, 18 nm, 20 nm, 25 nm, 30 nm, 36 nm, 40 nm, 45 nm, or 50 nm.

In some embodiments, the aluminum oxide layer includes: a third portion located on the first sub-pyramidal face, and a fourth portion located on the second sub-pyramidal face. The thickness non-uniformity between the first portion and the second portion in the passivation anti-reflection layer 2 is greater than a thickness non-uniformity between the third portion and the fourth portion in the aluminum oxide layer. For the thickness non-uniformity between the first portion and the second portion in the passivation anti-reflection layer 2, reference can be made to the foregoing description, and no more details will be given here. The thickness non-uniformity between the third portion and the fourth portion in the aluminum oxide layer is an absolute value of a difference between a third thickness of a third portion at a third position along the direction towards the pyramidal apex and a fourth thickness of the fourth portion at a fourth position along the direction towards the pyramidal apex, divided by a sum of the third thickness and the fourth thickness. Here, the third portion and the fourth portion are both defined along the same direction towards the pyramidal apex. Here, the third position in the third portion is any position in the third portion, and the fourth position in the fourth portion is any position in the fourth portion. The thickness non-uniformity between the first portion and the second portion in the passivation anti-reflection layer 2 is greater than the thickness non-uniformity between the third portion and the fourth portion in the aluminum oxide layer, that is, the thickness non-uniformity of the passivation anti-reflection layer 2 is greater. By matching the thickness of the passivation anti-reflection layer 2 with passivation requirements, it can be ensured that each position has an excellent passivation effect. In addition, in the present application, the thickness of the passivation anti-reflection layer is configured based on the passivation requirements, leading to reduced waste. In addition, in the present application, after light enters the passivation anti-reflection layer having different thicknesses, the light path changes more times, so that the optical length can be increased. In combination with the textured structure of the present application, the light absorption can be further increased, the light trapping effect is better, and the short-circuit current can be further improved; furthermore, the photoelectric conversion efficiency of the solar cell can be further improved. In addition, the solar cell is uniformly black in appearance and has a more aesthetically pleasing look. It needs to be noted that the specific difference between the two thickness non-uniformities is not specifically limited.

In some embodiments, the passivation anti-reflection layer 2 includes: a front-side passivation anti-reflection layer located on a light-facing surface of the silicon substrate 1, and a back-side passivation anti-reflection layer located on a back side of the silicon substrate 1. At two opposite positions in a thickness direction of the silicon substrate 1, a thickness of the back-side passivation anti-reflection layer is greater than a thickness of the front-side passivation anti-reflection layer. Specifically, if the thickness of the passivation anti-reflection layer is increased, the passivation effect of the passivation anti-reflection layer will be better, and the anti-reflection effect will be moderately reduced. For the passivation anti-reflection layer, the anti-reflection requirement on the back side is less than the anti-reflection requirement on the light-facing surface. Therefore, moderately increasing the thickness of the back-side passivation anti-reflection layer ensures an excellent passivation performance to be obtained on the back side, and moderately reducing the thickness of the front-side passivation anti-reflection layer can achieve both the passivation performance and the anti-reflection effect.

In some embodiments, at the two opposite positions in the thickness direction of the silicon substrate 1, the difference between the thickness of the back-side passivation anti-reflection layer and the thickness of the front-side passivation anti-reflection layer is greater than or equal to 15 nm and less than or equal to 40 nm. The difference between the two thicknesses is appropriately set, thereby fully ensuring an excellent passivation performance on the back side and at the same time a good passivation performance and anti-reflection effect on the light-facing surface; moreover, waste can be avoided. For example, the thickness of the back-side passivation anti-reflection layer can be 85 nm to 100 nm, or about 95 nm, and the thickness of the front-side passivation anti-reflection layer can be 60 nm to 70 nm, or about 65 nm. Here, at two opposite positions in the thickness direction of the silicon substrate 1, the difference between the thickness of the back-side passivation anti-reflection layer and the thickness of the front-side passivation anti-reflection layer can be 15 nm, or 16.3 nm, or 17.9 nm, or 19.4 nm, or 20.94 nm, or 22.6 nm, or 24.92 nm, or 27.5 nm, or 30.3 nm, or 32.6 nm, or 33.9 nm, or 35.7 nm, or 36.9 nm, or 18.34 nm, or 40 nm.

In some embodiments, referring to FIG. 2, the pyramidal face of the quasi-pyramidal structure has a branch-like texture 12, the shape of the branch-like texture 12 is similar to the shape of tree branches, and the branch-like texture 12 is a pattern with branches on a main trunk. A quantity of the branch-like texture 12 in the second sub-pyramidal face of the pyramidal face of the quasi-pyramidal structure is greater than a quantity of the branch-like texture 12 in the first sub-pyramidal face of the pyramidal face of the quasi-pyramidal structure away from the pyramidal apex. There is a correspondence between the branch-like texture 12 and a protrusion or depression on the pyramidal face of the quasi-pyramidal structure. A branch-like texture 12 is usually located at an interface between a protrusion and a depression on the pyramidal face of the quasi-pyramidal structure. That is, the more a quantity of the branch-like texture 12, the more the quantity of the protrusion and depression on the pyramidal face of the quasi-pyramidal structure; therefore, the more the texture, the greater the specific surface area of the textured structure, and the more irregular the distributed positions of the above branch-like texture, so that the textured structure can have a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 2, in the pyramidal face of the rightmost quasi-pyramidal structure, there is basically no branch-like texture on the first sub-pyramidal face away from the pyramidal apex, and there are a relatively large number of branch-like textures 12 on the second sub-pyramidal face.

In some embodiments, referring to FIG. 4, the pyramidal apex 11 of the quasi-pyramidal structure and the second sub-pyramidal face of the pyramidal face of the quasi-pyramidal structure have a cluster of ring-like textures 13 disposed in a nested manner. Here, the ring-like textures 13 can be ring-like patterns with open shapes, and/or the ring-like textures 13 can be ring-like patterns with closed shapes. For example, in FIG. 4, in a cluster of ring-like textures 13 disposed in a nested manner that are located at the central position and marked 13, both the patterns with open shapes and the patterns with closed shapes exist. Among the cluster of ring-like textures 13 disposed in a nested manner, a quantity of ring-like textures 13 is not specifically limited, and each of these ring-like textures 13 is nested with one another. The first sub-pyramidal face of the quasi-pyramidal structure has basically no ring-like texture. There is a correspondence between the above ring-like textures 13 and protrusions or depressions on the pyramidal face of the quasi-pyramidal structure. A ring-like texture 13 is usually located at an interface between a protrusion and a depression on the pyramidal face of the quasi-pyramidal structure. That is, the more the quantity of ring-like textures 13, the more the quantity of the protrusions and depressions on the pyramidal face of the quasi-pyramidal structure; therefore, the more the textures, the greater the specific surface area of the textured structure that can be increased, and the more irregular the distributed positions of the above ring-like textures, so that the textured structure can have a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

Referring to FIG. 4, the ring-like textures 13 here can be skirt-edge-like textures, that is, irregularly stacked skirt edge-like textures can be seen by electron microscope detection; and/or the ring-like textures 13 can be rose-flower-like textures, that is, irregularly stacked textures like the shape of a plurality of stacked layers of rose petals in a rose flower can be seen by electron microscope detection. As such, the ring-like textures 13 have an aesthetically pleasing look in shape, the reflectance is relatively low, and the light trapping effect is relatively good. The ring-like textures 13 are located on the pyramidal face and the pyramidal apex, or the ring-like textures 13 are further confined to the second sub-pyramidal face of the pyramidal face and the pyramidal apex.

In some embodiments, referring to FIG. 4, among the cluster of ring-like textures 13, along the height direction of the quasi-pyramidal structure, the closer a ring-like texture is to the pyramidal apex 11, the smaller a contour of the ring-like texture 13 is; and the farther away from the pyramidal apex 11, the larger the contour of the ring-like texture 13. The distributed positions of the above ring-like textures 13 are irregular, and thus the ring-like textures 13 can increase the specific surface area, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIGs. 1 to 5, a portion of the quasi-pyramidal structure away from the pyramidal apex 11 is a lower portion of the quasi-pyramidal structure, and a height of the lower portion is at least one tenth of a height of the quasi-pyramidal structure. In the pyramidal face of the quasi-pyramidal structure, the first sub-pyramidal face away from the pyramidal apex 11 is a region corresponding to the lower portion of the pyramidal face of the quasi-pyramidal structure; and the second sub-pyramidal face is a region of the pyramidal face of the quasi-pyramidal structure closer to the pyramidal apex 11 than the first sub-pyramidal face. Specifically, here, the division of the second sub-pyramidal face and the first sub-pyramidal face is relatively accurate, which not only facilitates the preparation of the textured structure but also leads to a lower reflectance and a better light trapping effect, so that the short-circuit current can be improved, and ultimately, the photoelectric conversion efficiency of the solar cell is improved. In addition, the solar cell is uniformly black in appearance and has a more aesthetically pleasing look. Herein, for the proportion of the height of the lower portion of the quasi-pyramidal structure, it should be understood that the foregoing effect can be achieved as long as the heights of the lower portions of most of the quasi-pyramidal structures in the textured structure satisfy the foregoing proportion.

For example, the portion of the quasi-pyramidal structure away from the pyramidal apex 11 is a lower portion of the quasi-pyramidal structure, and the height of the lower portion is one tenth, or two fifteenths, or three twentieths, or one ninth, or one eighth, or one seventh, or one seventh, or one fifth, or one fourth of the height of the quasi-pyramidal structure. In the pyramidal face of the quasi-pyramidal structure, the first sub-pyramidal face away from the pyramidal apex 11 is a region corresponding to the lower portion of the pyramidal face of the quasi-pyramidal structure; and the second sub-pyramidal face is a region of the pyramidal face of the quasi-pyramidal structure closer to the pyramidal apex 11 than the first sub-pyramidal face.

In some embodiments, the portion of the quasi-pyramidal structure away from the pyramidal apex 11 is a lower portion of the quasi-pyramidal structure, and the height of the lower portion is at least one fifth of the height of the quasi-pyramidal structure; the portion of the quasi-pyramidal structure immediately adjacent to the pyramidal apex 11 is an upper portion of the quasi-pyramidal structure, and the height of the upper portion is at most one fifth of the height of the quasi-pyramidal structure; and the portion of the quasi-pyramidal structure, which is located between the lower portion and the upper portion, is a middle portion, and the height of the middle portion is at least two fifths of the height of the quasi-pyramidal structure. In the pyramidal face of the quasi-pyramidal structure, the first sub-pyramidal face away from the pyramidal apex 11 is a region corresponding to the lower portion of the pyramidal face of the quasi-pyramidal structure. The second sub-pyramidal face is further divided into an upper sub-pyramidal face and a middle sub-pyramidal face. In the pyramidal face of the quasi-pyramidal structure, the upper sub-pyramidal face is a region corresponding to the upper portion of the pyramidal face of the quasi-pyramidal structure. In the pyramidal face of the quasi-pyramidal structure, the middle sub-pyramidal face is a region corresponding to the middle portion of the pyramidal face of the quasi-pyramidal structure. The division of the three sub-pyramidal face and the first sub-pyramidal face is relatively accurate, which not only facilitates the preparation of the textured structure but also leads to a lower reflectance and a better light trapping effect, so that the short-circuit current can be improved, and ultimately, the photoelectric conversion efficiency of the solar cell is improved. In addition, the solar cell is uniformly black in appearance and has a more aesthetically pleasing look. Herein, for the proportion of the height of the upper portion of the quasi-pyramidal structure, it should be understood that the foregoing effect can be achieved as long as the heights of the upper portions of most of the quasi-pyramidal structures in the textured structure satisfy the foregoing proportion. Similarly, herein, for the proportion of the height of the middle portion of the quasi-pyramidal structure, it should be understood that the foregoing effect can be achieved as long as the heights of the middle portions of most of the quasi-pyramidal structures in the textured structure satisfy the foregoing proportion.

For example, the portion of the quasi-pyramidal structure immediately adjacent to the pyramidal apex 11 is an upper portion of the quasi-pyramidal structure, and the height of the upper portion is one tenth, or two fifteenths, or three twentieths, or one ninth, or one eighth, or one seventh, or one sixth, or one fifth of the height of the quasi-pyramidal structure. Still for example, in the quasi-pyramidal structure, the portion located between the upper portion and the lower portion is a middle portion, and the height of the middle portion is two fifths, or thirteen thirtieths, or seven fifteenths, or one half, or eight fifteenths, or seventeen thirtieths, or three fifths of the height of the quasi-pyramidal structure.

In some embodiments, referring to FIGs. 3 and 4, the quasi-pyramidal structure further includes: a bottom contour line 14 away from the pyramidal apex 11, where at least two points in a same bottom contour line 14 have a height difference. As shown in FIG. 3, for the leftmost quasi-pyramidal structure, the middle quasi-pyramidal structure, and the rightmost quasi-pyramidal structure, all the bottom contour lines of the three structures have a height difference between a left endpoint and a right endpoint, and the shapes of the above quasi-pyramidal structures are more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIG. 1, the textured structure has an apex angle a of 55° to 90°, and the apex angle of the textured structure is an included angle between two opposite lateral edges that intersect at the pyramidal apex in the quasi-pyramidal structure. The textured structure has an apex angle a of 55° to 90°, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

For example, the apex angle a of the textured structure can be 55°, or 56°, or 59.3°, or 62°, or 70°, or 73.5°, or 78.6°, or 80.2°, or 84°, or 89.3°, or 90°.

In some embodiments, the quasi-pyramidal structure has a height of 0.2 µm (micrometers) to 3 µm, and the height of the quasi-pyramidal structure is relatively appropriate, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

For example, the height of the quasi-pyramidal structure can be 0.5 µm to 3 µm; or the height of the quasi-pyramidal structure can be 0.2 µm, or 0.31 µm, or 0.37 µm, or 0.42 µm, or 0.6 µm, or 0.73 µm, or 0.88 µm, or 0.95 µm, or 1.2 µm, or 1.24 µm, or 1.7 µm, or 1.99 µm, or 2.21 µm, or 2.7 µm, or 2.79 µm, or 3 µm.

In some embodiments, the quasi-pyramidal structure includes: a pyramidal apex 11, a pyramidal face, and at least two lateral edges. A lateral edge of the quasi-pyramidal structure is a side shared by adjacent side faces of the quasi-pyramidal structure. The lateral edge includes: a lower segment away from the pyramidal apex 11 and a first segment. Here, the bending degree of the lower segment is less than the bending degree of the first segment. The bending degree of a sub-segment of a lateral edge refers to the extent to which the sub-segment is bent. The shape of each lateral edge is irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 3, in the leftmost lateral edge of the leftmost quasi-pyramidal structure: the bending degree of the lower segment located to the left of L1 is less than the bending degree of the first segment located to the right of L1. In the rightmost lateral edge of the leftmost quasi-pyramidal structure: the bending degree of the lower segment located to the right of L2 is less than the bending degree of the first segment located to the left of L2.

In some embodiments, referring to FIG. 4, in the textured structure, at least the lower portions of at least two quasi-pyramidal structures away from the pyramidal apex 11 are fused, and the pyramidal vertices of the fused quasi-pyramidal structures 15 are separated apart, so that the textured structure is flexible and diverse in shape and easy to prepare. The pyramidal vertices of the fused quasi-pyramidal structures 15 are separated apart, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, in the textured structure, at least the lower portions of the two quasi-pyramidal structures enclosed by a brace at the left, away from the pyramidal vertices 11, are fused, and the pyramidal vertices of the fused quasi-pyramidal structures 15 are separated apart.

In some embodiments, in the direction perpendicular to the height of the quasi-pyramidal structure, the distance between the pyramidal vertices of the fused adjacent quasi-pyramidal structures 15 is greater than 0.2 µm, or can also be greater than 0.5 µm, for example, the distance can be 0.21 µm, or 0.31 µm, or 0.47 µm, or 0.5 µm, or 0.61 µm, or 0.77 µm, or 0.8 µm, or 0.88 µm, or 0.91 µm, or 1 µm, or 1.23 µm, or 1.34 µm, or 1.5 µm, or 1.6 µm.

In some embodiments, referring to FIG. 4, in the textured structure, at least the lower portions of at least two quasi-pyramidal structures away from the pyramidal apex 11 are fused, and the pyramidal vertices of the fused quasi-pyramidal structures 15 are different in height or are flush with each other, so that the textured structure is flexible and diverse in shape and easy to prepare, and the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, in the textured structure, at least the lower portions of the two quasi-pyramidal structures enclosed by a brace at the left, away from the pyramidal vertices 11, are fused, and the pyramidal vertices of the fused quasi-pyramidal structures 15 are different in height. Still for example, in FIG. 4, in the textured structure, at least the lower portions of the two quasi-pyramidal structures enclosed by a brace at the right, away from the pyramidal vertices 11, are fused, and the pyramidal vertices of the fused quasi-pyramidal structures 15 are approximately flush.

In some embodiments, referring to FIG. 4, in the textured structure, at least the lower portions of at least two quasi-pyramidal structures away from the pyramidal vertices 11 are fused, the pyramidal vertices of the fused quasi-pyramidal structures 15 are different in height, and the height difference is greater than 0 and less than or equal to 1.6 micrometers. The height difference is rationally set, so that the textured structure has a more proper specific surface area. On the one hand, the reflectance is lower and the light trapping effect is better; on the other hand, there is a difference between the thicknesses of the passivation anti-reflection layers formed at different sites, so that the incident light has a larger optical length, thereby increasing the light absorption.

For example, in the textured structure, at least the lower portions of the at least two quasi-pyramidal structures away from the pyramidal vertices 11 are fused, the pyramidal vertices of the fused quasi-pyramidal structures 15 are different in height, and the height difference can be 0.1 µm, or 0.17 µm, or 0.2 µm, or 0.31 µm, or 0.47 µm, or 0.5 µm, or 0.61 µm, or 0.77 µm, or 0.8 µm, or 0.88 µm, or 0.91 µm, or 1 µm, or 1.21 µm, or 1.34 µm, or 1.5 µm, or 1.6 µm.

In some embodiments, referring to FIG. 4, in the textured structure, at least the lower portions of at least two quasi-pyramidal structures away from the pyramidal vertices 11 are fused, the pyramidal vertices of the fused quasi-pyramidal structures 15 are different in height, and the height difference is greater than 0 and less than or equal to 0.8 micrometers. The height difference is smaller, so that the textured structure has a more proper specific surface area. On the one hand, the reflectance is lower and the light trapping effect is better; on the other hand, there is a difference between the thicknesses of the passivation anti-reflection layers formed at different sites, so that the incident light has a larger optical length, thereby increasing the light absorption.

For example, in the textured structure, at least the lower portions of the at least two quasi-pyramidal structures away from the pyramidal vertices 11 are fused, the pyramidal vertices of the fused quasi-pyramidal structures 15 are different in height, and the height difference can be 0.1 µm, or 0.13 µm, or 0.2 µm, or 0.33 µm, or 0.4 µm, or 0.47 µm, or 0.5 µm, or 0.61 µm, or 0.77 µm, or 0.8 µm.

In some embodiments, in the textured structure, at least the first sub-pyramidal faces of at least two quasi-pyramidal structures are fused, and the pyramidal vertices of the fused quasi-pyramidal structures are separated apart, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, in the textured structure, at least the first sub-pyramidal faces of the two quasi-pyramidal structures enclosed by the brace, away from the pyramidal vertices 11, are fused, and the pyramidal vertices of the fused quasi-pyramidal structures 15 are separated apart.

In some embodiments, in the fused quasi-pyramidal structures, the ring-like textures on the pyramidal faces of the different quasi-pyramidal structures are distributed separately, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, in the textured structure, at least the lower portions of the two quasi-pyramidal structures enclosed by a brace at the left, away from the pyramidal vertices 11, are fused, and the pyramidal vertices of the fused quasi-pyramidal structures 15 are separated apart. Alternatively, in the fused quasi-pyramidal structures, the ring-like textures on the pyramidal faces of the different quasi-pyramidal structures partially overlap, so that the textured structure is flexible and diverse, and the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, in the textured structure, at least the lower portions of the two quasi-pyramidal structures enclosed by a brace at the right, away from the pyramidal vertices 11, are fused, and the ring-like textures on the pyramidal faces of the different quasi-pyramidal structures in the fused quasi-pyramidal structures 15 partially overlap. Here, the outermost ring-like textures on the pyramidal faces of the different quasi-pyramidal structures in the fused quasi-pyramidal structures 15 can partially overlap.

In some embodiments, in a cluster of ring-like textures, the ring-like textures at different positions along the height direction of the quasi-pyramidal structure are distributed in an overlapping manner, so that the textured structure is flexible and diverse, and the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, in FIG. 4, among the cluster of ring-like textures marked 13 at the lowest, the ring-like textures 13 at different positions along the height direction of the quasi-pyramidal structure are distributed in an overlapping manner.

In some embodiments, in the pyramidal face of the quasi-pyramidal structure, the ring-like textures 13 extend from a position immediately adjacent to the pyramidal apex 11 at most to a position in the pyramidal face of the quasi-pyramidal structure, which corresponds to a portion of the quasi-pyramidal structure whose height difference from the pyramidal apex 11 is 2/3 of the height of the quasi-pyramidal structure, or the ring-like textures 13 can also extend from a position immediately adjacent to the pyramidal apex 11 at most to a position in a side face (i.e., a position in the pyramidal face) of the quasi-pyramidal structure, which corresponds to a portion of the quasi-pyramidal structure whose height difference from the pyramidal apex 11 is 1/2 of the height of the quasi-pyramidal structure. By adjusting the position of distribution of the ring-like textures 13, the position of concentrated distribution of protrusions and depressions on the side face can be adjusted, so that the textured structure, especially the upper half portion of the textured structure, has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, the maximum dimension d1 inside the ring-like textures 13 is 0.5 µm to 2 µm, and the maximum dimension d1 inside the ring-like textures 13 is rationally set. Not only is the preparation made easy, but also the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

For example, the maximum dimension d1 inside the ring-like textures 13 can be 0.5 µm, or 0.56 µm, or 0.61 µm, or 0.72 µm, or 0.93 µm, or 1 µm, or 1.12 µm, or 1.25 µm, or 1.31 µm, or 1.42 µm, or 1.53 µm, or 1.61 µm, or 1.77 µm, or 1.83 µm, or 1.92 µm, or 2 µm. Still for example, the maximum dimension d1 inside the ring-like textures 13 can be 0.55 µm to 1.8 µm, or the maximum dimension d1 inside the ring-like textures 13 can be 0.6 µm to 1.6 µm.

In some embodiments, referring to FIG. 4, in the same ring-like texture, the maximum dimensions inside the ring-like textures in at least two directions perpendicular to each other are not equal. That is, in the same ring-like texture, the maximum dimension inside the ring-like textures in a first direction is different from the maximum dimension inside the ring-like textures in a second direction perpendicular to the first direction, so that the shape of the textured structure is more irregular, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIG. 4, in the same cluster of ring-like textures, at least one of the ring-like textures 13 has a spike 131 that points outward from the ring-like texture 13. The spike 131 can increase the specific surface area, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIGs. 1 to 5, for two lateral edges located at two sides of the pyramidal apex 11 in the same quasi-pyramidal structure, the dimension of one lateral edge is greater than the dimension of the other lateral edge along the thickness direction of the silicon substrate, which makes the shape of the quasi-pyramidal structure more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIGs. 1 to 4, for two adjacent quasi-pyramidal structures, one lateral edge having a smaller size in one quasi-pyramidal structure is distributed immediately adjacent to the other lateral edge having a smaller size in the other quasi-pyramidal structure, which makes the shape of the textured structure more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, referring to FIGs. 1 to 4, in one lateral edge, a lower segment away from the pyramidal apex 11 is a linear segment, or a segment having at most two inflection points. Specifically, for example, the lower segment is a linear segment having only one slope. In this case, the lower segment has no inflection point. Alternatively, the lower segment is composed of two segments. The two segments can be a linear segment and a curve segment, where a position where the linear segment and the curve segment intersect with each other has one inflection point; or the two segments can be two linear segments, where the slopes of the two linear segments are different, and a position where the two linear segments intersect with each other has one inflection point. Alternatively, the lower segment is composed of three segments, which can be a linear segment, another linear segment, and a curve segment, where the slopes of the two linear segments are different, and each of the positions where the three intersect with one another has one inflection point. Alternatively, the lower segment can be composed of three linear segments, where the slopes of the three linear segments are different, and the position where two adjacent straight lines intersect with each other has one inflection point. The lower segment here can be obtained by using an existing texturing method and parameters, demonstrating better process compatibility.

In some embodiments, referring to FIGs. 1 to 4, in one lateral edge, the first segment other than the lower segment is a polyline segment and/or a curve segment. A quantity of polyline segments or curve segments included in the first segment is not specifically limited. Thus, the shape of the textured structure is more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

For example, in FIG. 3, in the left lateral edge of the leftmost quasi-pyramidal structure: the lower segment located to the left of L1 is composed of two linear segments and has one inflection point, and the first segment located to the right of L1 is composed of a plurality of polyline segments and a plurality of curve segments. In the right lateral edge of the leftmost quasi-pyramidal structure: the lower segment located to the right of L2 is composed of a linear segment and has no inflection point, and the first segment located to the left of L2 is composed of a plurality of polyline segments and a plurality of curve segments. In the left lateral edge of the middle quasi-pyramidal structure: the lower segment located to the left of L3 is composed of two linear segments and has one inflection point, and the first segment located to the right of L3 is composed of a plurality of polyline segments and a plurality of curve segments. In the right lateral edge of the middle quasi-pyramidal structure: the lower segment located to the right of L4 is composed of three linear segments and has two inflection points, and the first segment located to the left of L4 is composed of a plurality of polyline segments and a plurality of curve segments. In the left lateral edge of the rightmost quasi-pyramidal structure: the lower segment located to the left of L5 is composed of two linear segments and has one inflection point, and the first segment located to the right of L5 is composed of a plurality of polyline segments and a plurality of curve segments. In the right lateral edge of the rightmost quasi-pyramidal structure: the lower segment located to the right of L6 is composed of a linear segment and has no inflection point, and the first segment located to the left of L6 is composed of a plurality of polyline segments and a plurality of curve segments.

In some embodiments, the length of the lower segment of one lateral edge is at least one tenth of the length of the lateral edge. Here, in one lateral edge, the lower segment and the first segment are accurately divided, which not only facilitates the preparation of the textured structure but also leads to a lower reflectance and a better light trapping effect, so that the short-circuit current can be improved, and ultimately, the photoelectric conversion efficiency of the solar cell is improved. In addition, the solar cell is uniformly black in appearance and has a more aesthetically pleasing look.

For example, the length of the lower segment of one lateral edge is one tenth, or two fifteenths, or three twentieths, or one ninth, or one eighth, or one seventh, or one sixth, or one fifth, or one fourth of the length of the lateral edge.

A first plane perpendicular to the thickness direction of the silicon substrate 1 is a plane defined by the direction of the length and the direction of the width of the silicon substrate 1. Alternatively, when the solar cell is placed on a horizontal plane, the light-facing surface or the back side of the silicon substrate 1 faces away from the horizontal plane, and the first plane here is parallel to the horizontal plane. For example, in FIG. 3, a horizontal dashed line extending to left and right is a schematic diagram of the first plane. Still for example, in FIG. 5, a horizontal dashed line extending to left and right is a schematic diagram of the first plane. In some embodiments, the included angle between the lower segment of one lateral edge and the first plane perpendicular to the thickness direction of the silicon substrate 1 is less than the included angle between the first segment of the lateral edge and the first plane. Specifically, the rate of corrosion by a chemical liquid in each crystal direction of the silicon substrate is adjusted by a corrosion additive, and the lateral edge is irregularly corroded, which makes the shape of the textured structure more irregular, so that the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look.

In some embodiments, the first segment of one lateral edge is composed of an upper segment and a middle segment. The upper segment here is immediately adjacent to the pyramidal apex 11, and the middle segment is located between the lower segment and the upper segment. The length of the upper segment is at least one tenth of the length of the lateral edge, and the length of the middle segment is at least two fifths of the length of the lateral edge. Specifically, the lower segment is a portion of one lateral edge farthest away from the pyramidal apex 11, or the lower segment is the lowermost portion of the lateral edge; the upper segment is a portion of the lateral edge that is closest to the pyramidal apex 11, or the upper segment is the uppermost portion of the lateral edge; and the middle segment is a portion located in the middle of the lateral edge. The foregoing accurate division of the positions of the lower segment, the upper segment, and the middle segment not only facilitates the preparation of the textured structure but also leads to a lower reflectance and a better light trapping effect, so that the short-circuit current can be improved, and ultimately, the photoelectric conversion efficiency of the solar cell is improved. In addition, the solar cell is uniformly black in appearance and has a more aesthetically pleasing look.

For example, the length of the upper segment of one lateral edge is one tenth, or two fifteenths, or three twentieths, or one ninth, or one eighth, or one seventh, or one seventh, or one fifth, or one fourth of the length of the lateral edge. In one lateral edge, a portion other than the lower segment and the upper segment is the middle segment. For example, the length of the middle segment of one lateral edge is two fifths, or thirteen thirtieths, or seven fifteenths, or one half, or eight fifteenths, or seventeen thirtieths, or three fifths of the length of the lateral edge.

In some embodiments, referring to FIG. 3, the included angle b between the lower segment of one lateral edge and the first plane is 50° to 55°; and referring to FIG. 5, the included angle c between the upper segment and the first plane is 55° to 80°, and the included angle between the middle segment and the first plane is 55° to 85°. In FIG. 5, solid white lines are reverse extension lines of the upper segments. The included angles between the three sub-segments and the first plane are rationally set, so that the preparation is made easy; in addition, the portion of the quasi-pyramidal structure close to the pyramidal apex 11 is sharper, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. When the lower segment of one lateral edge is a single linear segment, the included angle b between the lower segment of the lateral edge and the first plane can be the included angle between the linear segment and the first plane. For example, in FIG. 3, when the lower segment of the right lateral edge of the leftmost quasi-pyramidal structure, located to the right of L2, is a single linear segment, the included angle b between the lower segment of the right lateral edge and the first plane can be the included angle between the linear segment and the first plane. When the lower segment of one lateral edge is not a single linear segment, the included angle b between the lower segment of the lateral edge and the first plane can be the included angle between the first plane and a linear segment that lies in the lower segment of the lateral edge and to which a lower endpoint of the lower segment belongs. For example, in FIG. 3, a lower segment that lies in the left lateral edge of the leftmost quasi-pyramidal structure and is located to the left of L1 is composed of two linear segments and has one inflection point. In other words, the lower segment of the lateral edge is composed of a first linear segment and a second linear segment, which are connected from top to bottom. In this case, the included angle b between the lower segment of the lateral edge and the first plane can be the included angle between the first plane and a linear segment to which the lower endpoint of the lower segment belongs, i.e., the second linear segment, or also a line connecting the lower endpoint of the lower segment to the inflection point closest to the lower endpoint of the lower segment. When the upper segment of one lateral edge is a single linear segment, the included angle c between the upper segment of the lateral edge and the first plane can be the included angle between the linear segment and the first plane. When the upper segment of one lateral edge is not a single linear segment, the included angle c between the upper segment of the lateral edge and the first plane can be the included angle between a line, which connects the upper endpoint of the upper segment to the lower endpoint of the upper segment, and the first plane. Similarly, the included angle between the middle segment of one lateral edge and the first plane can be the included angle between a line, which connects the upper endpoint of the middle segment to the lower endpoint of the middle segment, and the first plane.

In some embodiments, at least one of the light-facing surface of the silicon substrate 1 and/or the back surface of the silicon substrate 1 has any one of the foregoing textured structures. Thus, the position at which the textured structure of the silicon substrate 1 is disposed is flexible, and the textured structure has a larger specific surface area, leading to a lower reflectance and a better light trapping effect, and thus the short-circuit current can be improved, and ultimately, the photoelectric conversion efficiency of the solar cell is improved. In addition, the solar cell is uniformly black in appearance and has a more aesthetically pleasing look. For example, at least the light-facing surface of the solar cell has any one of the foregoing textured structures. Still for example, the solar cell is a bifacial solar cell, where the light-facing surface of the silicon substrate 1 has any one of the foregoing textured structures, or the back surface of the silicon substrate 1 has any one of the foregoing textured structures, or both the light-facing surface and the back surface of the silicon substrate 1 have any one of the foregoing textured structures. Still for example, the solar cell is a back-contact solar cell, where the light-facing surface of the silicon substrate 1 has any one of the foregoing textured structures. Still for example, the solar cell is a back-contact solar cell, where the back surface of the silicon substrate 1 has any one of the foregoing textured structures. Still for example, the solar cell is a back-contact solar cell, where both the light-facing surface and the back surface of the silicon substrate 1 have any one of the foregoing textured structures. Still for example, the solar cell is a back-contact solar cell, where, whether the light-facing surface of the silicon substrate 1 has the foregoing textured structure is not limited; and the back surface of the silicon substrate 1 includes: a first region and a second region, which are alternately distributed. The first region here is doped with a first conductive element, or the first region is provided with a first conductive layer doped with the first conductive element; and at least some portions of the second region are doped with a second conductive element, or at least some portions of the second region are provided with a second conductive layer doped with the second conductive element. Here, the first conduction element corresponds to a first conduction type, and the second conduction element corresponds to a second conduction type. The first conduction type and the second conduction type are different in conduction type. The first region has any one of the foregoing textured structures, or the second region has any one of the foregoing textured structures, or both the first region and the second region have any one of the foregoing textured structures. Alternatively, the second region is provided with any one of the foregoing textured structures except the portions doped with the second conductive element. Alternatively, the second region is provided with any one of the foregoing textured structures except the portions provided with the second conductive layer. Still for example, the solar cell is a back-contact solar cell, where whether the light-facing surface of the silicon substrate 1 has the foregoing textured structure is not limited; and the back surface of the silicon substrate 1 includes: a first region and a second region, which are alternately distributed. Here, a first conductive layer is prepared on the first region, and a second conductive layer is prepared on the second region. The first conductive layer and the second conductive layer here are different in conduction type. An isolation region can be provided between the first region and the second region, and the isolation region can have any one of the foregoing textured structures, or at least one of the first region, the second region, and the isolation region can have any one of the foregoing textured structures. Still for example, the solar cell is a back-contact solar cell, where whether the light-facing surface of the silicon substrate 1 has the foregoing textured structure is not limited; and the back surface of the silicon substrate 1 includes: a first region and a second region, which are alternately distributed. Here, a first conductive layer is prepared on the first region, and a second conductive layer is prepared on the second region. The first conductive layer and the second conductive layer here are different in conduction type. The first conductive layer and the second conductive layer at least partially overlap, and an insulation structure is provided between the overlapping portion of the first conductive layer and the second conductive layer. At least one of the first region and the second region can have any one of the foregoing textured structures. The foregoing conduction types are different and can respectively have p-type and n-type doping in some cases. Still for example, the solar cell is a back-contact solar cell, where the back surface of the silicon substrate 1 includes: an n-type region and a p-type region, which are alternately distributed, where the p-type region is used for collecting and conducting holes, the n-type region is used for collecting and conducting electrons, and an isolation region is provided between adjacent n-type region and p-type region. The light-facing surface of the silicon substrate 1 has any one of the foregoing textured structures, and/or the isolation region has any one of the foregoing textured structures. The n-type region and the p-type region are both relatively flat, and the formed film layers such as a conductive layer and a passivation layer have a relatively good quality. There is no need to prepare a conduction layer in the isolation region. The provided textured structure can provide a lower reflectance and improve the light trapping effect, making the electrical performance of the back-contact solar cell better. Still for example, the solar cell is a back-contact solar cell, where the back surface of the silicon substrate 1 includes: an n-type region and a p-type region, which are alternately distributed, where the p-type region has any one of the foregoing textured structures, and the light-facing surface of the silicon substrate 1 has any one of the foregoing textured structures.

The present application further provides a photovoltaic module, including: a plurality of any one of the foregoing solar cells, and a quantity of the solar cells in the photovoltaic module is not specifically limited. The photovoltaic module can further include encapsulation adhesive films located on both sides of the back-contact solar cell, etc. Other structures of the photovoltaic module are not specifically limited.

The present application further provides a method for preparing a solar cell. The preparation method is used for preparing any one of the foregoing solar cells. The preparation method includes: subjecting a silicon substrate 1 to primary texturing, washing the silicon substrate 1 after the primary texturing, and subjecting the washed silicon substrate 1 to secondary texturing, where the secondary texturing here refers to irregular corrosion on a textured structure obtained after the primary texturing, and the secondary texturing can reduce an internal dimension of a bottom contour line of the quasi-pyramidal structure away from the pyramidal apex, so that the pyramidal face is coarser, etc., thereby forming sharper quasi-pyramidal structures. The textured structure of the present application can be obtained by adjusting the process conditions of the secondary texturing, or by selecting a different additive for the secondary texturing from that for the primary texturing.

In some embodiments, during the secondary texturing: the composition of the additive in a texturing liquid can includes: sodium benzoate, a defoaming agent, and a surfactant; and/or the mass content of the additive in the texturing liquid is 0.01% to 5%; and/or the temperature of the texturing liquid is 50°C to 85°C; and/or the time length of the secondary texturing is 30 s (seconds) to 400 s, which is appropriate for setting the process parameters of the secondary texturing, so that any one of the foregoing textured structures is easy to prepare. The textured structure of the present application can be obtained by adjusting the process conditions of the secondary texturing, or by selecting a different additive for the secondary texturing from that for the primary texturing. The foregoing texturing method can also be referred to as wet texturing. The actual structure of the textured structure obtained by means of wet texturing is relatively complicated, making it difficult to ensure the consistency of the morphologies of all quasi-pyramidal structures in the textured structure. It should be understood that the effect described in the present application can be achieved as long as the morphologies of most of the quasi-pyramidal structures in the textured structure satisfy the features of the foregoing morphological structures.

The present application is further explained and described below with reference to a specific example.

### Example

Step 1: A single crystal silicon wafer was preliminarily textured with an alkali to form a pyramid structure on the surface. The specific type of the alkali solution was not specifically limited and could be selected from at least one of a sodium hydroxide (NaOH) solution and a potassium hydroxide (KOH) solution, and the height of the formed pyramid was 0.5 µm to 3 µm. More specifically, the texturing liquid in step 1 could be a first reaction liquid formed by mixing an NaOH solution or KOH solution having a mass concentration of 1% to 9% with additive A; and the primary texturing was completed at a temperature ranging from 60°C to 85°C within 150 s to 600 s. Specifically, the washed single crystal silicon wafer was placed in the foregoing first reaction liquid for primary texturing within the foregoing temperature range and time length range to form pyramid structures. The pyramid structures had a height of 0.5 µm to 3 µm. The main components of additive A included a surfactant, a dispersant, and an emulsifier. In the primary texturing process, the mass percentage of the added additive A was 0.01% to 5%.

Step 2: The single crystal silicon wafer textured with the alkali in step 1 was washed with DI water (deionized water) to remove the residual chemical solution.

Step 3: The above pyramid texture washed with DI water were subjected to auxiliary polishing and secondary texturing corrosion by means of polishing and texturing solutions. The rate of corrosion by the chemical liquid in each crystal direction of the crystal silicon was adjusted by means of the additive. Irregular corrosion occurred on the pyramidal face of the pyramid texture, and further corrosion of the pyramid occurred inwards, so that the width of the pyramid was gradually narrowed and the included angle between an lateral edge and the first plane gradually increased, thereby forming a textured structure with a quasi-pyramidal structure having a lower reflectance. During secondary texturing: the composition of the additive in a texturing liquid can include: sodium benzoate, a defoaming agent, and a surfactant, and the mass content of the additive in the texturing liquid was 0.01% to 5%. The texturing liquid in step 2 could be obtained by mixing an NaOH solution or KOH solution having a mass concentration of 1% to 15% with sodium benzoate, a defoaming agent, and a surfactant. The temperature of the texturing liquid was 50°C to 85°C, such as 60°C to 85°C, and the time length of the secondary texturing was 30 s to 400 s, such as 30 s to 240 s. The NaOH solution or KOH solution here could also be replaced by an organic alkali, and the organic alkali could be one of tetramethylammonium hydroxide, ethylenediamine, ethyltriamine, methylenediamine, and tetrabutylammonium hydroxide.

Step 4: The single crystal silicon wafer treated in step 3 was washed with DI water, a mixture an alkali and hydrogen peroxide, etc., to remove chemical residuals from the surface. In step 4, the total time length of washing was 60 s to 150 s, and the washing temperature was 50°C to 70°C.

Step 5: The structure obtained in step 4 was washed with ozone, an acid, etc., to form a hydrophobic surface, facilitating production in a subsequent procedure.

In step 5, in the finally formed quasi-pyramidal structure, the included angle between a lateral edge and the first face was in a range of 50° to 85°. More specifically, the lateral edge was divided into an upper segment immediately adjacent to the pyramidal apex, a lower segment farthest away from the pyramidal apex, and a middle segment located between the lower segment and the upper segment. The length of the lower segment accounted for 1/4 of the length of the lateral edge, the length of the middle segment accounted for 1/2 of the length of the lateral edge, and the length of the upper segment accounted for 1/4 of the length of the lateral edge. Alternatively, the portion of the quasi-pyramidal structure away from the pyramidal apex was a lower portion of the quasi-pyramidal structure, the height of the lower portion accounted for 1/4 of the height of the quasi-pyramidal structure, and the lower segment was a portion corresponding to the lower portion of the lateral edge. The portion of the quasi-pyramidal structure immediately adjacent to the pyramidal apex was an upper portion of the quasi-pyramidal structure, the height of the upper portion accounted for 1/4 of the height of the quasi-pyramidal structure, and the upper segment was a portion corresponding to the upper portion of the lateral edge. The portion located between the upper portion and the lower portion in the quasi-pyramidal structure was the middle portion, the height of the middle portion accounted for 1/2 of the height of the quasi-pyramidal structure, and the middle segment was a portion corresponding to the middle portion of the lateral edge. The included angle between the lower segment and the first plane was 50° to 55°, the included angle c between the upper segment and the first plane was 55° to 80°, and the included angle between the middle segment and the first plane was 55° to 85°. The textured structure of the silicon substrate of the finally prepared solar cell in the example was as shown in FIGs. 1 to 3 and 5. The maximum dimension inside the bottom contour line of the quasi-pyramidal structure was 10 nm to 200 nm.

Step 6: Structures such as a passivation anti-reflection layer were further prepared on the single crystal silicon wafer obtained in step 5, to obtain a solar cell.

### Comparative Example

This comparative example included only steps 1, 4, 5, and 6 in the foregoing example. Steps 1, 4, 5, and 6 were sequentially performed, and steps 1, 4, 5, and 6 respectively corresponded to and were the same as steps 1, 4, 5, and 6 in the example.

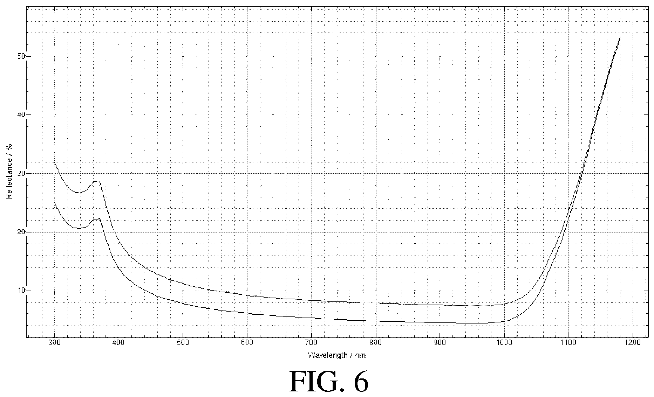

In the same test environment, the solar cells of the example and comparative example were tested for the reflectance on the side where a textured structure was provided. The test results are as shown in FIG. 6. In FIG. 6, the abscissa is the wavelength of light irradiated on the solar cell, in nm, and the ordinate is reflectance. In FIG. 6, a blue curve (the lower curve) is used for representing the corresponding reflectance in the example, and a red curve (the upper curve) is used for representing the corresponding reflectance in the comparative example. It can be concluded that in most wavelength ranges that can be utilized by solar cells, the reflectance of the textured structure of the solar cell of the example is lower.

In the same test environment, the solar cells of the example and comparative example were tested for electrical performance. The test results are as shown in the following table.

**Table of comparison in electrical performance between the solar cells of the tested example and comparative example**

| Group | Eta (%) | Voc (mV) | Isc (A) | FF (%) |
|---|---|---|---|---|
| Comparative Example | 24.741 | 731.2 | 13.901 | 81.47 |
| Example | 24.950 | 731.5 | 14.004 | 81.52 |

In the above table, Eta refers to photoelectric conversion efficiency, Voc refers to an open circuit voltage, Isc refers to a short-circuit current, and FF refers to a conversion factor. It can be concluded from the above table that the photoelectric conversion efficiency, open circuit voltage, short-circuit current, and conversion factor of the solar cell of the example are all higher than those of the solar cell of the comparative example. The main reason is that by means of the improvement of the textured structure in the example, the reflectance is reduced and the light trapping effect is improved, so that the short-circuit current can be improved, and ultimately, the photoelectric conversion efficiency of the solar cell is improved.

It needs to be noted that throughout the text, contents having the same name can be cross-referenced with each other. In order to avoid repetition, no more details will be given in each corresponding place.

It needs to be noted that for ease of description, the method embodiments are stated as a combination of a series of actions. However, a person skilled in the art should be aware that the embodiments of the present application are not limited to the described action sequence, because according to the embodiments of the present application, some steps can be performed in another sequence or simultaneously. In addition, a person skilled in the art should also be aware that the embodiments described in the description are all preferred embodiments, and the actions involved are not necessarily required by the embodiments of the present application.

It needs to be noted that the terms "include", "comprise", or any other variants thereof herein are intended to cover non-exclusive inclusion, so that a process, a method, an object, or a device that includes a series of elements includes not only these elements but also other elements that are not explicitly listed, or can further include inherent elements of the process, method, object, or device. Without more limitations, an element defined by the statement "including a ..." does not exclude the presence of other identical elements in the process, method, object, or device in which this element is included.

According to the description of the foregoing implementations, a person skilled in the art can clearly understand that the method according to the foregoing embodiments can be implemented by means of softwares and necessary general hardware platforms, and certainly, can alternatively be implemented by hardwares. In many cases, the former manner is better for the implementation. Based on such an understanding, the technical solutions of the present application essentially, or the part contributing to the related art, can be implemented in the form of a software product. The computer software product is stored in a storage medium (such as a read-only memory (ROM)/random access memory (RAM), a magnetic disk, or an optical disc) and includes a plurality of instructions for instructing a terminal (which can be a mobile phone, a computer, a server, an air conditioner, a network device, etc.) to perform the method described in each of the embodiments of the present application.

The embodiments of the present application are described above with reference to the accompanying drawings. However, the present application is not limited to the foregoing specific implementations. The foregoing specific implementations are only illustrative instead of limitative. Inspired by the present application, a person of ordinary skill in the art can make many forms without departing from the gist of the present application and the scope of protection of the claims, and these forms all fall within the protection of the present application.

## Claims

1. A solar cell, comprising: a silicon substrate and a passivation anti-reflection layer located on the silicon substrate, wherein
a surface of the silicon substrate has a textured structure comprising: a plurality of quasi-pyramidal structures; a quasi-pyramidal structure comprises: a pyramidal face and a pyramidal apex; the pyramidal face of the quasi-pyramidal structure comprises: a first sub-pyramidal face away from the pyramidal apex, and a second sub-pyramidal face, wherein the second sub-pyramidal face is the remaining portion of the pyramidal face of the quasi-pyramidal structure other than the first sub-pyramidal face; and in the pyramidal face of the quasi-pyramidal structure, a surface morphology of the first sub-pyramidal face is different from a surface morphology of the second sub-pyramidal face; and
the passivation anti-reflection layer comprises: a first portion located on the first sub-pyramidal face, and a second portion located on the second sub-pyramidal face; and a thickness of the first portion of the passivation anti-reflection layer along a direction towards the pyramidal apex is greater than a thickness of the second portion of the passivation anti-reflection layer along the direction towards the pyramidal apex.

2. The solar cell according to claim 1, wherein a surface fluctuation of the first sub-pyramidal face is less than surface fluctuation of the second sub-pyramidal face; or
a roughness of the first sub-pyramidal face is less than roughness of the second sub-pyramidal face.

3. The solar cell according to claim 1, wherein the thickness of the first portion of the passivation anti-reflection layer is greater than a thickness of a portion of the passivation anti-reflection layer at the pyramidal apex; and/or
a thickness of a portion of the passivation anti-reflection layer at a position where adjacent quasi-pyramidal structures abut is greater than the thickness of the portion of the passivation anti-reflection layer at the pyramidal apex; and/or
the thickness of the portion of the passivation anti-reflection layer at the position where adjacent quasi-pyramidal structures abut is greater than the thickness of the second portion of the passivation anti-reflection layer.

4. The solar cell according to claim 1, wherein in the passivation anti-reflection layer, a thickness non-uniformity between the first portion and the second portion is greater than 4%; wherein the thickness non-uniformity is an absolute value of a difference between a first thickness of the first portion at a first position along the direction towards the pyramidal apex and a second thickness of the second portion at a second position along the direction towards the pyramidal apex, divided by a sum of the first thickness and the second thickness.

5. The solar cell according to claim 1, further comprising: an aluminum oxide layer located between the silicon substrate and the passivation anti-reflection layer, wherein:
the aluminum oxide layer comprises: a third portion located on the first sub-pyramidal face, and a fourth portion located on the second sub-pyramidal face;
a thickness non-uniformity between the first portion and the second portion in the passivation anti-reflection layer is greater than a thickness non-uniformity between the third portion and the fourth portion in the aluminum oxide layer;
the thickness non-uniformity between the first portion and the second portion in the passivation anti-reflection layer is an absolute value of a difference between a first thickness of the first portion at a first position along the direction towards the pyramidal apex and a second thickness of the second portion at a second position along the direction towards the pyramidal apex, divided by a sum of the first thickness and the second thickness; and
the thickness non-uniformity between the third portion and the fourth portion in the aluminum oxide layer is an absolute value of a difference between a third thickness of the third portion at a third position along the direction towards the pyramidal apex and a fourth thickness of the fourth portion at a fourth position along the direction towards the pyramidal apex, divided by a sum of the third thickness and the fourth thickness.

6. The solar cell according to claim 1, wherein the passivation anti-reflection layer comprises: a front-side passivation anti-reflection layer located on a light-facing surface of the silicon substrate, and a back-side passivation anti-reflection layer located on a back side of the silicon substrate; and
at two opposite positions in a thickness direction of the silicon substrate, a thickness of the back-side passivation anti-reflection layer is greater than a thickness of the front-side passivation anti-reflection layer.

7. The solar cell according to claim 6, wherein at the two opposite positions in the thickness direction of the silicon substrate, a difference between the thickness of the back-side passivation anti-reflection layer and the thickness of the front-side passivation anti-reflection layer is greater than or equal to 15 nm and less than or equal to 40 nm.

8. The solar cell according to claim 1, wherein the pyramidal face of the quasi-pyramidal structure has a branch-like texture, and a quantity of the branch-like texture in the second sub-pyramidal face is greater than a quantity of the branch-like texture in the first sub-pyramidal face.

9. The solar cell according to claim 1, wherein the pyramidal apex of the quasi-pyramidal structure and the second sub-pyramidal face of the pyramidal face of the quasi-pyramidal structure have a cluster of ring-like textures disposed in a nested manner.

10. The solar cell according to claim 9, wherein among the cluster of ring-like textures, along a height direction of the quasi-pyramidal structure, the closer a ring-like texture is to the pyramidal apex, the smaller a contour of the ring-like texture is.

11. The solar cell according to any one of claims 1 to 10, wherein a portion of the quasi-pyramidal structure away from the pyramidal apex is a lower portion of the quasi-pyramidal structure, and a height of the lower portion is at least one-tenth of a height of the quasi-pyramidal structure;
the first sub-pyramidal face is a region corresponding to the lower portion of the pyramidal face of the quasi-pyramidal structure; and
the second sub-pyramidal face is a region of the pyramidal face of the quasi-pyramidal structure closer to the pyramidal apex than the first sub-pyramidal face.

12. The solar cell according to any one of claims 1 to 10, wherein the quasi-pyramidal structure further comprises: a bottom contour line away from the pyramidal apex, wherein at least two points in a same bottom contour line have a height difference.

13. The solar cell according to any one of claims 1 to 10, wherein the textured structure has an apex angle of 55° to 90°.

14. The solar cell according to any one of claims 1 to 10, wherein the quasi-pyramidal structure has a height of 0.2 µm to 3 µm.

15. The solar cell according to any one of claims 1 to 10, wherein at least one of a light-facing surface of the silicon substrate and/or a back surface of the silicon substrate has the textured structure.

16. A photovoltaic module, comprising: a plurality of solar cells according to any one of claims 1 to 15.
